# EUROPEAN PATENT APPLICATION

(11) **EP 0 551 648 A2**
(43) Date of publication of application: **21.07.1993**
(21) Application number: 92121871.5
(22) Date of filing: 23.12.1992
(51) Int. Cl.: G01R 31/28, H04B 17/00, G06F 11/22

(54) **Method of, system and board for testing an electronic equipment, particularly a telecommunication equipment**

(30) Priority: 15.01.1992 IT MI920060; 15.09.1992 IT MI922121
(71) Applicant: ALCATEL ITALIA S.p.A., I-20149 Milano (IT)
(72) Inventor: Barillari, Maurizio, Milano (IT); Lisca, Lorenzo, Milano (IT); Baldi, Mariano, I-84100 Salerno (IT); Rotunno, Antonio, I-84100 Salerno (IT)
(74) Representative: Pohl, Herbert, Dipl.-Ing

(57) **Abstract**

There is disclosed a method,system and board for testing an electronic equipment, particularly a telecommunication equipment.

Conventionally the electronic equipments are tested as to their functionality, once assembled, as black-boxes, through dedicated test systems.

Nearly always, and above all in the field of telecommunication, equipments are composed of set of boards interconnected through a bus and communicating in time division, according to a predetermined protocol.

The method according to the present invention proposes to test, as to functionality, with a single apparatus all the individual boards composing the equipment, naturally by using different test sequences.

## Description

The present invention relates to a method,a system and a board for testing an electronic equipment, particularly a telecommunication equipment of the type comprising printed board assemblies interconnected through a bus and communicating each other in time division according to a predetermined protocol.

Conventionally, electronic equipments are tested, as to their functionality,once they are assembled only and in the manner of black-boxes.

In case of telecommunication equipment,dedicated test systems are used : a review on such types of systems can be found in "Telecommunication Test Systems" Electrical Communication Vol 65, No 1,pages 60 to 66.

Such systems, however versatile they are made through the use of personal computers for the control of their functionality and the preparation and analysis of test sequences, remain strictly connected to the type of equipment (conventional, SDN, ISDN, ATM, SDH,....) and to the type of test (simulation of calls and traffic, protocol analysis,...).

Even PCM line monitors, which de facto do not carry out any test but limit themselves to giving information on data travelling on such lines,are connected to the particular type of contemplated signalling.

Moreover, the complexity of the functional test, executed according to the "black-box" method, of an equipment composed of a high number of printed boards is extremely high and increases much more rapidly as the architectural complexity increases.

It is an object of the prevent invention to provide a method of testing functionally an electronic equipment which is more versatile, simple and complete than the conventional method and to provide a sole system which is able to carry out different tests on different electronic equipments. This object is achieved by the method of testing an electronic equipment having the characteristics set forth in claim 1, by the system having tie characteristics set forth in claim 8 and by the board having the characteristics set forth in claim 9.Further advantageous aspects of the present invention are set forth in the subclaims.

In electronic equipments composed of a high number of PBAs (Printed Board Assemblies), such boards are connected and communicate each other through a bus according to a well defined protocol; in case of telecommunication equipments, e.g. concentrators or exchange, the structure of such bus and the protocol correspond, as a rule,to a serial bus on which multiple PCM signals (24 or 32 channels) travel with a certain rate (64 Kbits/s, 2 Mbits/s, 4 Mbits/s).

All the boards of the electronic equipments then communicate through such bus by means of respective interfaces connected thereto, which implement the well defined protocol.

By testing functionally and separately the single boards through such interfaces,the complexity of the test is reduced and made independent of the architectural complexity of the electronic equipment: consequently a greater test completeness and also a greater test reliability can be obtained since the boards, each time tested, operate as if they were in the real working environment, i.e. the test is transparent to them. Moreover, the interface being unique, a sole test system is sufficient by using different test sequences, of course.

This does not exclude the need of testing the whole equipment once assembled but, at this point, only an integration test remains to be carried out, being already sure of the correct operation of single parts.

But in the special case of telecommunication equipments,similar interfaces are often used also for inputs and outputs and therefore the same system can be even used for testing the whole equipment.

The invention will now be described in detail hereinafter with reference to the attached drawings wherein :
- Fig.1 shows an architecture of an electronic equipment to which the test method and system according to the present invention are to be applied,
- Fig.2 shows a test system according to the present invention connected with one of the printed boards of the equipment in fig.1,and
- Fig.3 shows one of possible embodiments of the Test board according to the present invention, which can be used in the test system of Fig.2.

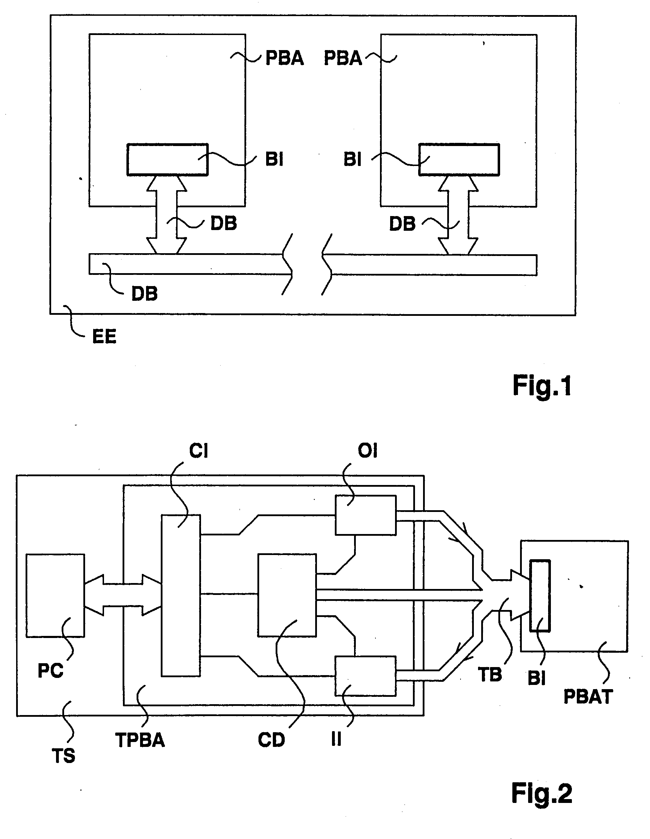

In fig.1, EE designates an electronic equipment, to which the test method and system according to the present invention are to be applied, comprising a number of boards PBA and a bus DB. The boards PBA are provided with an interface BI and are electrically connected with bus DB through such interface BI. The boards PBA communicate each other in time division according to a predetermined protocol.

What described above can be applied both to telecommunication equipments, e.g. exchanges, and to other electronic equipments, e.g. computers. If the equipments are rather complicated, as in the case of exchanges, several busses electrically not connected each other may be therein, but what is important is the fact that they are identical or at least compatible as to both electrical structure and protocol.
Firstly,the method according to the present invention suggests to functionally test the boards PBA of the equipment EE one at a time through a suitable test system (TS, fig.2.) : the test of the equipment is then divided in a number, equal to the number of boards PBA, of board tests.

According to the type of test to be carried out, the test system (TS, fig.2) is connected to the board (PBAT, fig.2) to be tested through a test bus (TB, fig.2) structurally and functionally identical to the bus DB of the equipment, after having disconnected it (PBAT)from the latter (DB), or (TS) is connected to the equipment bus DB.

Secondly, the board test passes through the following steps :
a) memorize a test sequence
b) send first signals, corresponding to said test sequence, to said board according to said predetermined protocol,
c) receive, according to said predetermined protocol, second signals emitted by said board in relation to the sending of said test sequence and corresponding to a response sequence, and
d) memorize said response sequence.

Should the test system (TS, fig.2) be connected to the equipment bus DB, it is necessary to put first an addressing phase of the test board (PBAT, fig.2) before sending the sequence; such addressing phase can be merely composed of a temporary mechanical interruption of the activity of other boards not to be tested.

If the preparation of the test sequence and the analysis of the response sequence are carried out by an operator, e.g. the designer of the electronic equipment or of one of the boards, memorization step a) will be preceded by a step of reception by the operator of the test sequence in a suitable format, and memorization step d) will be followed by a step of outputting the response sequence in a suitable format.

It is clear that input formats of test sequence and of outputting the response sequence should be such as to help operations of preparation and analysis by the operator ; from this point of view a suitably programmed personal computer can be advantageously used such as to operate the conversion from the format suitable for the operator to the one suitable for the electronic equipment and viceversa, and to offer an "amicable" interface to the operator, which is a widespread practice in the field of informatics and of telematics.

Naturally the test of a board may consist of a number of test cycles each comprising the above-mentioned steps; test sequences used in various cycles can be equal or different according to the board to be tested and the test strategy used. Such test sequences can be fixed in advance, before starting the test operation, or can be chosen during the test operation : e.g. the test sequence relative to a cycle can be chosen according to one or more response sequences relative to previous cycles.

The preparation of the test sequences and the analysis of the response sequences can be also executed in an automatic manner, e.g. on the basis of technical specifications of the electronic equipment as a whole and of single boards.

In fig.2 there is illustrated a system TS adapted to implement the method according to the present invention just described.

In such figure reference is made to the case in which the test system TS is connected through a test bus TB to a board to be tested PBAT of the electronic equipment EE shown in fig.1,or also to the case of testing an entire electronic equipment EE equipped with such an interface BI for its inputs and outputs.

The case in which test system TS is connected to the bus DB of the equipment EE is anyhow structurally the same, as said.

Like all boards PBA of the equipment EE, also the board PBAT to be tested is equipped with an interface BI which test bus TB is connected to.

The test system TS comprised a computer PC adapted to memorize and process said test and response sequences,and a test board PBA electrically connected to computer PC and designed to receive from computer PC test sequences and retransmit them on test bus TB,to receive from test bus TB response sequences,and retransmit them to computer PC, and to receive and transmit control commands from and to computer PC.
As visible in Fig.2,test board TBA is conceptually composed of:
a) an output interface OI adapted to send said test sequences according to said predetermined protocol,
b) an input interface II adapted to receive said response sequences according to said predetermined protocol,
c) a control device CD, electrically connected to said input interface II and to said output interface OI, receiving at least a timing signal and adapted to control the receiving and sending of said sequences, and
d) an interface CI to said computer, electrically connected to said output interface OI and to said input interface II for data exchange, and adapted to transmit and receive commands to and from said control device CD.

Sending of a test sequence and reception of said response sequence occur, according to the cases already seen, either over the bus DB of the equipment EE or over the test bus TB.

The connections of interface CI with the two interfaces OI and II must be considered as logic ones since such sequences follow the above-mentioned paths;they may correspond also to real electrical paths but there is nothing to prevent the device from executing processes on them and therefore the physical paths from passing through such device.

Reception of timing signal occurs, as a rule, from one of the two busses. Sometimes such a signal can be obtained from signals travelling over the bus itself. Very often at least a timing signal is contemplated in the bus :
in case of computers it is known as clock, in case of serial busses for multichannel PCM signals there are two timing signals, one for the bit and one for identifying the frame beginnings.

Often it happens that single boards do not generate autonomously a timing signal but this task is given in charge to only one special board of the electronic equipment EE ; in such instance if the test system TS is connected with the bus DB of the equipment such special board is already connected to bus DB and therefore both test system TS and board PBAT to be tested can utilize the timing signal generated by it, while if the test system TS is connected directly to the board PBAT to be tested, it will be necessary to arrange a different circuitry adapted to generate such signal.

The content of blocks listed at a), b), c), d), is well known to those skilled in the art and, in particular, activities of blocks a), b), c), can be carried out by a suitably programmed Texas Instruments 320C25 processor,and block d) can be realized by few logic circuits such as to allow connection of such processor bus to the bus of computer PC.

Computer PC is advantageously a personal computer ; in this case, given the relative simplicity of the remaining circuitry, which is often realized with broad use of integrated circuits,the remaining circuitry can be located on a test board TPBA to be connected directly to the bus of the personal computer : interface CI to the computer shall be then a well known interface for personal computer bus.

As said several times, signals travelling over the bus can be of the type multichannel PCM or V24,in which case input interface II and output interface OI must be adapted to operate on such kind of signals : circuital solutions suitable for realizing them can be found in circuits of the boards PBA of the equipment to be tested.

In order to be able to operate in transmission and reception at high rates it is better that interfaces II and OI are provided with internal memories designed to memorize data temporarily.

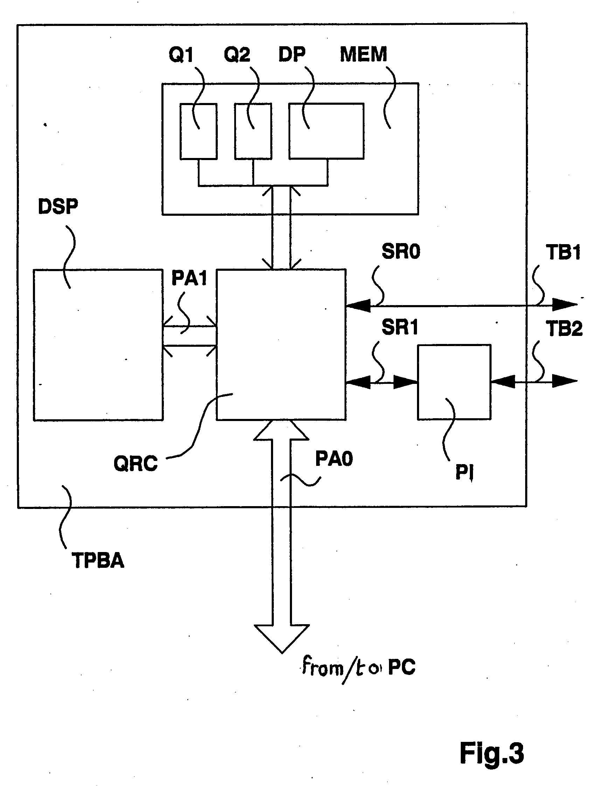

One of the possible embodiments of the board TPBA is shown in fig.3.
Such board consists essentially of a communication processor QRC,electrically connected to a random access memory MEM. Such a processor QRC is described in the European Patent Application EP91120547 and contains inside it,in an its integrated embodiment,two serial interfaces (having inputs/outputs SRO and SR1)of type multichannel PCM,two parallel interfaces (having inputs/outputs PA0 and PA1),an interface for the connection with an external memory,a control device and an internal memory. Processor QRC is able to configurate memory MEM as a number of independent memory blocks of various types,e.g. FIFO,LIFO,circular queue,multipoint memory.
Connected with one of the parallel ports,PA0 in fig.3,is a processor,computer PC in fig.3,able to control and determine the behaviour of processor QRC.

Inthe present embodiment memory MEM is configurated as two FIFO memory blocks Q1 and Q2 also called queues:and the processor QRC accumulates in queue Q1 the test sequences as they are received by computer PC and in queue Q2 the response sequences as they are received by one of the serial ports SR0 and SR1.The handling of queues Q1 and Q2 is completely under the control of processor QRC as far as write and read out are concerned.
The choice of the serial port is carried out through sending of suitable commands by computer PC.
As can be seen from fig.3,disposed in series with port SR1 is a protocol interface PI able to convert the multichannel PCM signal into a type V24 signal.Therefore the choice of the two ports depends on the electronic equipments to be tested.

Should the application require it,a digital signal processor DSP can be electrically connected to the second parallel port PA1 to operate digital processing on the test sequences to be transmitted and on the received response sequences.
In this case it is necessary to provide the configuraion of the memory MEM with a further block DP of type multiport memory,i.e. which can be accessed by several processors at the same time. In such block DP,the computer PC transfers the program to be processed by processor DSP; moreover,processor DSP uses the remaining cells of block DP,not occupied by the program,as working storage.
The possibilities offered by such hardware structure are very high,in particular due to versatility of processor QRC.

## Claims

1. Method of testing an electronic equipment, particularly a telecommunication equipment of the type including boards connected each other through a bus and communicating in time division according to a predetermined protocol, characterized in that said boards are tested separately in relation to their functionality and that the testing of a board comprises the steps of
a) memorizing a test sequence,
b) sending first signals, corresponding to said test sequence, to said board according to said predetermined protocol,
c) receiving (through said bus), according to said predetermined protocol, second signals emitted by said board in relation to the sending of said test sequence and corresponding to the response sequence, and
d) memorizing said response sequence.

2. Method according to claim 1, characterized in that said boards are tested separately through connection of a test system with one of said boards at a time.

3. Method according to claim 1, characterized in that said boards are tested separately through connection of a test system to said bus and by putting first a step of addressing the board to be tested before said sending stop.

4. Method according to claim 1, characterized in that said testing of a board further comprises the stop of putting out said response sequence in a suitable format.

5. Method according to claim 1,characterized in that the testing of a board further comprises the step of receiving by an operator said test sequence in a suitable format.

6. Method according to claim 1, characterized in that said testing of a board comprises a number of test cycles each comprising said steps a), b), c), d).

7. Method according to claim 6,characterized in that the test sequence relative to a cycle depends on the response sequence relative to at least a previous cycle.

8. System for testing an electronic equipment,in particular a telecommunication equipment,by respectively sending test sequences and receiving response sequences on and from a bus according to a predetermined protocol,and designed to implement the method of claim 1,characterized in that it comprises a computer capable of storing and processing said test and response sequences,and a test board electrically connected to said computer and adapted to receive from said computer said test sequences and retransmit them on said bus, to receive from said bus said response sequences and retransmit them to said computer,and and to receive and transmit control commands respecpectively from and to said computer.

9. Board for testing, an electronic equipment particularly a telecommunication equipment,adapted to be used in the system of claim 8,characterized in that it comprises :
a) an output interface adapted to send said test sequences according to said predetermined protocol,
b) an input interface adapted to receive said response sequences according to said predetermined protocol,
c) a control device electrically connected to said input interface and to said output interface, receiving at least one timing signal and designed to control reception and sending of said sequences, and
d) an interface to said computer, electrically connected to said output interface and to said input interface for data exchange and designed to transmit and receive commands to and from said control device .

10. Board according to claim 9,characterized in that said output interface and said input interface are adapted to operate on signals type multichannel PCM.

11. Board according to claim 9, characterized in that said output interface and said input interface are adapted to operate on signals of the type V24.

12. Board according to claim 9, characterized in that said output interface and said input interface comprise internal memories capable of storing data temporarily.

13. Board according to claim 9,characterized in that said interface to said computer is of the type connectable to a computer bus.

14. Board according to claim 9, characterized in that said control device consists of a communication processor electrically connected by a RAM memory configured by said communication processor as at least a pair of data queues ,one of such queues receiving at the input,from said interface to said computer,said test sequences,the other of said queues receiving at its input said response sequences from said input interface, both said queues being handled by said communication processor.

15. Board according to claim 14,characterized in that it further comprised a digital signal processor electrically connected to said communication processor,capable of carrying out digital processings on said test sequences to be transmitted and on said received response sequences and in that said RAM memory is configurated additionally as a double-port memory section capable of containing data and program of said digital signal processor ,said program coming from said computer.
